# EUROPÄISCHE PATENTSCHRIFT

(11) **EP 0 978 145 B1**
(45) Veröffentlichungstag und Bekanntmachung des Hinweises auf die Patenterteilung: **26.06.2002**
(21) Anmeldenummer: 98931895.1
(22) Anmeldetag: 09.04.1998
(51) Int. Cl.: H01L 29/86, H02H 9/00

(54) **HALBLEITER STROMBEGRENZER UND DEREN VERWENDUNG**
SEMI-CONDUCTOR DEVICE AND USE THEREOF
LIMITEUR DE COURANT A SEMICONDUCTEUR ET SON UTILISATION

(30) Priorität: 25.04.1997 DE 19717614
(43) Veröffentlichungstag der Anmeldung: 09.02.2000
(73) Patentinhaber: SiCED Electronics Development GmbH & Co KG, 91052 Erlangen (DE)
(72) Erfinder: BARTSCH, Wolfgang, D-91054 Erlangen (DE); MITLEHNER, Heinz, D-91080 Uttenreuth (DE); STEPHANI, Dietrich, D-91088 Bubenreuth (DE)
(74) Vertreter: Berg, Peter
(86) Internationale Anmeldenummer: DE9801030
(87) Internationale Veröffentlichungsnummer: WO9849733

(56) Entgegenhaltungen:
- WO-A-95/07548
- WO-A-96/19831
- WO-A-97/23911
- DE-U- 9 411 601
- FR-E- 92 860

## Beschreibung

Die Erfindung betrifft eine Halbleiteranordnung, die zum passiven Begrenzen eines elektrischen Stromes geeignet ist, sowie deren Verwendung.

Zum Versorgen eines elektrischen Verbrauchers (Gerätes) mit einem elektrischen Strom wird der Verbraucher über ein Schaltgerät mit einem Leitungsabzweig eines elektrisches Versorgungsnetzes verbunden. Zum Schutz des Verbrauchers vor zu hohen Strömen, insbesondere im Kurzschlußfall, wird in der Niederspannungsschalttechnik ein Schaltgerät mit einem den Leitungsabzweig schützenden Trenner, für den im allgemeinen eine Schmelzsicherung verwendet wird, und mit einem mechanischen Leistungsschalter mit einer Schaltzeit von deutlich mehr als einer Millisekunde (1 ms) eingesetzt. Werden in einem Leitungsabzweig mehrere Verbraucher gleichzeitig betrieben und tritt bei nur einem dieser Verbraucher ein Kurzschluß auf, so ist es von großem Vorteil, wenn die nicht mit dem Kurzschluß behafteten Verbraucher ungestört weiterarbeiten können und nur der vom Kurzschluß betroffene Verbraucher abgeschaltet wird. Zu diesem Zweck sind unmittelbar vor jeden Verbraucher geschaltete strombegrenzende Bauelemente ("Limiter") notwendig, die jeweils innerhalb einer Zeit von deutlich weniger als 1 ms und somit vor dem Auslösen des für den Leitungsabzweig vorgesehenen Trenners den Strom von dem prospektiven Kurzschlußstrom sicher auf einen vorgegebenen, nicht kritischen Überstromwert begrenzen. Diese strombegrenzenden Bauelemente sollten überdies passiv ohne Ansteuerung arbeiten und die im Strombegrenzungsfall anstehenden Spannungen von üblicherweise bis zu 700 V und bisweilen bis zu 1200 V aushalten können. Da die dann im Bauelement entstehende Verlustleistung sehr hoch ist, wäre es besonders vorteilhaft, wenn der passive Strombegrenzer zusätzlich den Strom auf Werte deutlich unterhalb des vorgegebenen Überstromwertes unter zusätzlicher Aufnahme von Spannung selbsttätig reduzieren würde (eigensicheres Bauelement).

Der einzige am Markt erhältliche passive Strombegrenzer ist das in dem Aufsatz *"Polyäthylen-Stromwächter für den Kurzschlußschutz*" *von T. Hansson, ABB Technik 4*/*92, Seiten 35-38* beschriebene Gerät mit dem Produktnamen PROLIM, das auf einer stromabhängigen Leitfähigkeit der Korngrenzen des in diesem Gerät eingesetzten Materials beruht. Jedoch kann bei häufigerem Gebrauch des Geräts zur Strombegrenzung eine Änderung des Stromsättigungswertes, bei dem der Strom begrenzt wird, auftreten.

In der *WO-A-96*/*19831* und in der *WO-A 95*/*07548* wird jeweils ein passiver Strombegrenzer beschrieben. Die offenbarten Halbleiteranordnungen weisen jeweils ein erstes Halbleitergebiet auf, in dem weitere Halbleitergebiete angeordnet sind, die jeweils mit dem ersten Halbleitergebiet einen p-n-Übergang bilden. Zwischen den weiteren Halbleitergebieten sind innerhalb des ersten Halbleitergebiets jeweils vertikale Kanalgebiete vorhanden, die zur Strombegrenzung dienen. Die weiteren Halbleitergebiete sind nicht gesondert kontaktiert. Sie sind vielmehr entweder floatend innerhalb des ersten Halbleitergebiets angeordnet oder gemeinsam mit dem ersten Halbleitergebiet kontaktiert. Mit diesen Halbleiteranordnungen lässt sich der Strom zwar passiv auf einen Sättigungsstromwert begrenzen, allerdings bleibt dieser relativ hohe Sättigungsstrom auch bei weiter steigender Spännung erhalten. Dadurch besteht die Gefahr, dass die Halbleiteranordnungen zerstört werden.

Ansonsten werden im allgemeinen nur aktive Strombegrenzer eingesetzt, die den Strom erfassen und bei Überschreiten eines vorgegebenen Maximalstromwertes durch aktives Steuern begrenzen. Aus *DE-U-9411601* ist ein solcher aktiver Strombegrenzer auf Halbleiterbasis bekannt. Dieser weist ein erstes Halbleitergebiet eines vorgegebenen Leitungstyps auf, dem an voneinander abgewandten Oberflächen jeweils eine Elektrode zugeordnet sind. In dem ersten Halbleitergebiet sind nun zwischen den beiden Elektroden weitere Halbleitergebiete vom entgegengesetzten Leitungstyp voneinander beabstandet angeordnet. Zwischen den weiteren Halbleitergebieten sind jeweils Kanalgebiete des ersten Halbleitergebietes gebildet, die senkrecht zu den beiden Oberflächen des ersten Halbleitergebietes gerichtet sind (vertikale Kanäle). Ein vertikaler Stromfluß zwischen den beiden Elektroden wird durch diese Kanalgebiete geführt und dadurch begrenzt. Zur Steuerung des Stromflusses zwischen den beiden Elektroden wird an die entgegengesetzt dotierten Halbleitergebiete in dem ersten Halbleitergebiet eine Gatespannung angelegt, durch die die Widerstände der Kanalgebiete gesteuert werden.

Der Erfindung liegt nun die Aufgabe zugrunde, eine Halbleiteranordnung anzugeben, die zum sicheren und passiven Begrenzen von elektrischen Strömen bei Überschreiten eines kritischen Stromwertes eingesetzt werden kann. Es soll auch eine Strombegrenzeranordnung mit einer solchen Halbleiteranordnung angegeben werden.

Diese Aufgabe wird gemäß der Erfindung gelöst mit den Merkmalen des Anspruchs 1.

Die Halbleiteranordnung umfaßt
a) ein erstes Halbleitergebiet, das an einer ersten Oberfläche in wenigstens einem Kontaktgebiet mit einer ersten Elektrode kontaktiert ist und an einer zweiten Oberfläche mit einer zweiten Elektrode kontaktiert ist,
b) wenigstens ein zweites Halbleitergebiet, das mit dem ersten Halbleitergebiet einen p-n-Übergang bildet,
c) wenigstens ein drittes Halbleitergebiet, das mit dem ersten Halbleitergebiet einen p-n-Übergang bildet,
   wobei
d) das dritte Halbleitergebiet an seiner nicht an das erste Halbleitergebiet angrenzenden Oberfläche isoliert ist, so daß elektrische Ladungen im dritten Halbleitergebiet speicherbar sind,
e) das erste Halbleitergebiet wenigstens ein in einem Strompfad zwischen den beiden Elektroden liegendes Kanalgebiet aufweist, das bei Erreichen eines vorgegebenen Sättigungsstromes zwischen den beiden Elektroden von Verarmungszonen der genannten p-n-Übergänge abgeschnürt wird, wonach der Strom auf einen Wert unterhalb des Sättigungsstromes begrenzt wird.

Diese Halbleiteranordnung begrenzt durch eine vorteilhafte Kombination von physikalischen Effekten im Kanalgebiet selbsttätig einen Strom, insbesondere einen Kurzschlußstrom, auf einen akzeptablen Stromwert. Ferner ist die Halbleiteranordnung imstande, diesen akzeptablen Stromwert wegen der Ladungsspeicherung im elektrisch isolierten dritten Halbleitergebiet und der daraus resultierenden anhaltenden Abschnürung des Kanalgebietes auch bei anschließenden Spannungsabnahmen an den beiden Elektroden im wesentlichen beizubehalten.

Vorteilhafte Ausgestaltungen und Weiterbildungen der Halbleiteranordnungen ergeben sich aus den abhängigen Ansprüchen. Vorteilhafte Verwendungen der Halbleiteranordnung für Strombegrenzeranordnungen ergeben sich aus den Ansprüchen 16 und 17.

In einer besonders vorteilhaften und besonders durchbruchsfesten Ausführungsform der Halbleiteranordnung ist das zweite Halbleitergebiet innerhalb des ersten Halbleitergebietes unterhalb des Kontaktgebiets angeordnet ist und verläuft in allen Richtungen parallel zur Oberfläche des ersten Halbleitergebiets weiter als das Kontaktgebiet.

Das dritte Halbleitergebiet umgibt vorzugsweise das Kontaktgebiet parallel zur ersten Oberfläche des ersten Halbleitergebietes.

Ein vertikaler und dadurch besonders spannungsfester Aufbau der Halbleiteranordnung wird dadurch erreicht, daß die zweite Oberfläche des ersten Halbleitergebietes von der ersten Oberfläche abgewandt ist.

Vorzugsweise sind an der ersten Oberfläche des ersten Halbleitergebietes mehrere Kontaktgebiete vorgesehen, denen insbesondere eine gemeinsame Elektrode zugeordnet ist.

Es kann nun unterhalb der Kontaktgebiete ein zusammenhängendes zweites Halbleitergebiet angeordnet sein, das in allen Richtungen parallel zur ersten Oberfläche des ersten Halbleitergebietes weiter ausgedehnt ist als die Gesamtheit der Kontaktgebiete, und vorzugsweise Öffnungen aufweist, durch die elektrisch in Reihe zu den genannten Kanalgebieten geschaltete weitere Kanalgebiete im ersten Halbleitergebiet, vorzugsweise vertikal, verlaufen.

Es können aber auch unterhalb jedes Kontaktgebietes jeweils ein zugehöriges zweites Halbleitergebiet im ersten Halbleitergebiet angeordnet sein, zwischen denen zusätzliche Kanalgebiete des ersten Halbleitergebietes verlaufen, die im Strompfad elektrisch in Reihe zu jeweils wenigstens einem der den Kontaktgebieten zugeordneten Kanalgebieten liegen.

Bevorzugt ist jedes dritte Halbleitergebiet an seiner nicht an das erste Halbleitergebiet angrenzenden Oberfläche mit einem Isolatorgebiet bedeckt ist. Die Spannungsfestigkeit des Isolatorgebietes beträgt vorzugsweise wenigstens 20 V, insbesondere wenigstens 50 V zwischen erster Elektrode und drittem Halbleitergebiet, die elektrische Durchbruchsfeldstärke vorzugsweise wenigstens 5 MV/cm.

Als Halbleiter für die Halbleiteranordnung wird vorzugsweise ein Halbleiter mit einem Bandabstand von mindestens 2 eV verwendet, der sich durch eine niedrige intrinsische Ladungsträgerkonzentration (Ladungsträgerkonzentration ohne Dotierung) auszeichnet, die wiederum den Ladungsspeichereffekt positiv beeinflußt.

Der Ladungsspeicherungseffekt ist besonders groß, wenn als Halbleitermaterial für die Halbleitergebiete der Halbleiteranordnung Siliciumcarbid (SiC) vorgesehen ist, da SiC eine extrem niedrige intrinsische Ladungsträgerkonzentration aufweist. Weitere Vorteile von SiC sind seine hohe Durchbruchsfestigkeit, hohe Temperaturbeständigkeit, chemische Resistenz und hohe Wärmeleitfähigkeit. Bevorzugte Polytypen des SiC sind der 4H-, der 6H- und der 3C-Polytyp. Bevorzugte Dotierstoffe für SiC sind Bor und Aluminium für p-Dotierung und Stickstoff für n-Dotierung. Es sind jedoch auch andere Halbleiter geeignet, insbesondere Silicium (Si).

Sowohl bei SiC als auch bei Si als Halbleiter wird für das Isolatorgebiet vorzugsweise das Dielektrikum Siliciumdioxid (SiO₂) verwendet, das insbesondere thermisch gewachsen wird. Thermisches Oxid weist hervorragende Isolationseigenschaften auf. Es wird auf SiC vorzugsweise durch Trocken- oder Naßoxidation bei Temperaturen über etwa 1000°C erzeugt.

Ein Gleichstrombegrenzer wird realisiert, indem eine Elektrode der Halbleiteranordnung mit der Stromquelle und die andere Elektrode mit dem Verbraucher elektrisch verbindbar ist.

Ein Wechselstrombegrenzer wird in vorteilhafter Weise durch antiserielles Verschalten zweier Halbleiteranordnungen zwischen die Stromquelle und den elektrischen Verbraucher verwirklicht. Die Ladungsspeicherung in den dritten Halbleitergebieten verhindert, daß der Strom bei Polaritätswechsel der Wechselspannung immer wieder angeschaltet wird.

Ausführungsbeispiele der Erfindung werden anhand der Zeichnung erläutert. Diese zeigt in ihrer
- FIG 1: eine Ausführungsform einer Halbleiteranordnung mit einem lateralen Kanalgebiet,
- FIG 2: eine Ausführungsform einer Halbleiteranordnung mit lateralen und vertikalen Kanalgebieten,
- FIG 3: eine Halbleiteranordnung mit einem Zelldesign in einer teils Draufsicht,
- FIG 4: ein Wechselstrombegrenzer mit zwei antiseriell geschalteten Halbleiteranordnungen,
- FIG 5: eine gemessene Kennlinie eines Wechselstrombegrenzers gemäß FIG 4,
- FIG 6: der zeitliche Verlauf von Strom und Spannung einer Halbleiteranordnung im Kurzschlußfall in einem Diagramm und
- FIG 7: eine Schalteinrichtung mit einem Strombegrenzer in einem Leitungsabzweig.

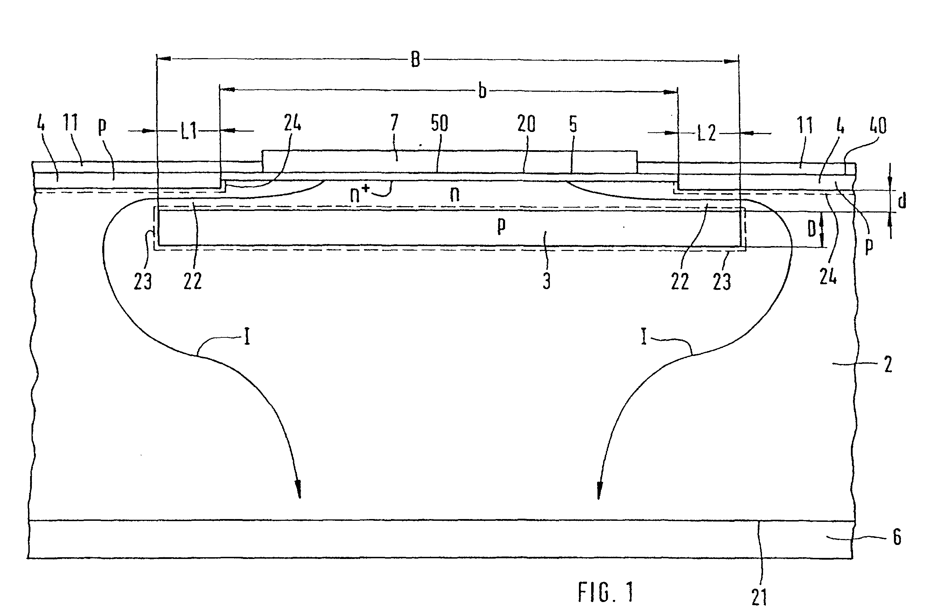

Die in FIG 1 dargestellte Halbleiteranordnung umfaßt ein erstes Halbleitergebiet 2 vom n-Leitungstyp (Elektronenleitung) und ein zweites Halbleitergebiet 3 sowie ein drittes Halbleitergebiet 4 vom p-Leitungstyp (Löcherleitung). Das erste Halbleitergebiet 2 weist eine planare (ebene) Oberfläche 20 auf. Das zweite Halbleitergebiet 3 ist unterhalb dieser Oberfläche 20 innerhalb des ersten Halbleitergebiets 2 angeordnet und verläuft wenigstens an seiner der Oberfläche 20 des ersten Halbleitergebiets 2 zugewandten Seite lateral, d.h. im wesentlichen parallel zur Oberfläche 20 des ersten Halbleitergebiets 2. Vorzugsweise wird das zweite Halbleitergebiet 3 durch Ionenimplantation von Dotierstoffteilchen in die Oberfläche 20 des ersten Halbleitergebiets 2 erzeugt. Ein gewünschtes Dotierprofil wird durch das Eindringprofil bei der Ionenimplantation mittels der Ionenenergie unter Berücksichtigung etwaiger Implantationsmasken eingestellt. Insbesondere ergeben sich daraus die Tiefe des zweiten Halbleitergebietes 3, d.h. der Abstand dieses zweiten Halbleitergebietes 3 von der Oberfläche 20 des ersten Halbleitergebietes 2 und die vertikale, d.h. senkrecht zur Oberfläche 20 des ersten Halbleitergebiets 2 gemessene, Ausdehnung D des zweiten Halbleitergebiets 3. Diese vertikale Ausdehnung D beträgt insbesondere zwischen 0,1 µm und 1,0 µm. Die laterale Ausdehnung des zweiten Halbleitergebiets 3 parallel zur Oberfläche 20 des ersten Halbleitergebiets 2 im dargestellten Querschnitt ist mit B bezeichnet und im allgemeinen zwischen etwa 10 µm und etwa 30 µm gewählt. Zwischen dem ersten Halbleitergebiet 2 und dem entgegengesetzt dotierten zweiten Halbleitergebiet 3 ist ein p-n-Übergang gebildet, dessen Verarmungszone (Raumladungszone) mit 23 bezeichnet ist. Die Verarmungszone 23 des p-n-Übergangs umgibt das gesamte zweite Halbleitergebiet 3.

An der Oberfläche 20 des ersten Halbleitergebiets 2 ist ein Kontaktgebiet 5 als ohmscher Kontakt vorgesehen. Das Kontaktgebiet 5 ist vorzugsweise höher dotiert und vom gleichen Leitungstyp wie das erste Halbleitergebiet 2, im dargestellten Ausführungsbeispiel durch n⁺ angedeutet, und kann insbesondere durch Ionenimplantation erzeugt sein. Auf einer freien Oberfläche 50 des Kontaktgebiets 5 ist eine erste Elektrode 7 angeordnet, beispielsweise aus Polysilicium oder einem Metall. Die laterale Ausdehnung des Kontaktgebiets 5 im dargestellten Querschnitt ist mit b bezeichnet und ist in allen Richtungen parallel zur Oberfläche 20 des ersten Halbleitergebiets 2 kleiner als die laterale Ausdehnung B des zweiten Halbleitergebiets 3. Üblicherweise liegt die laterale Ausdehnung b des Kontaktgebietes zwischen etwa 6 µm und etwa 28 µm. Das zweite Halbleitergebiet 3 und das Kontaktgebiet 5 sind relativ zueinander so angeordnet, daß in einer Projektion senkrecht zur Oberfläche 20 des ersten Halbleitergebiets 2 die Projektion des Kontaktgebiets 5 vollständig innerhalb der Projektion des zweiten Halbleitergebiets 3 liegt.

Das dritte Halbleitergebiet 4 ist ebenfalls an der Oberfläche 20 des ersten Halbleitergebietes 2 angeordnet und vorzugsweise ebenfalls durch Ionenimplantation erzeugt. Zwischen dem ersten Halbleitergebiet 2 und dem dritten Halbleitergebiet 4 ist ein p-n-Übergang gebildet, dessen Verarmungszone mit 24 bezeichnet ist. Die Ausdehnungen der Verarmungszonen 23 und 24 sind gestrichelt und nur in dem ersten Halbleitergebiet 2 eingezeichnet. Natürlich dehnen sich die Verarmungszonen 23 und 24 auch in die jeweiligen p-Halbleitergebiete 3 bzw. 4 aus. Die Ausdehnung jeder Verarmungszone eines p-n-Übergangs in das p-Gebiet und das n-Gebiet richtet sich dabei nach der Maßgabe der sich aus den Dotierkonzentrationen ergebenden Ladungsträgerkonzentrationen gemäß dem Poisson-Gesetz und dem Prinzip der Ladungserhaltung. Die Dotierungen des ersten Halbleitergebietes 2, des zweiten Halbleitergebietes 3 und des dritten Halbleitergebietes 4 bestimmen die Sperrfähigkeit der Halbleiteranordnung, wenn zwischen den beiden Elektroden 6 und 7 eine Spannung in Sperrichtung anliegt.

Nach Ionenimplantation der Halbleitergebiete 3, 4 und 5 werden im allgemeinen thermische Ausheilverfahren durchgeführt, um Gitterdefekte zu reduzieren.

Auf der freien, nicht an das erste Halbleitergebiet 2 angrenzenden Oberfläche 40 des dritten Halbleitergebiets 4 ist nun ein Isolatorgebiet 11 angeordnet, das auch einen angrenzenden Randbereich des Kontaktgebietes 5 bedeckt. Dieses Isolatorgebiet 11 isoliert das dritte Halbleitergebiet 4 elektrisch und verhindert ein Abfließen von aus der Verarmungszone 23 des p-n-Übergangs in eine Raumladungszone im dritten Halbleitergebiet 4 diffundierten Ladungen (im dargestellten Fall Elektronen) aus dem dritten Halbleitergebiet 4. Eine weitere Funktion des Isolatorgebiets 11 ist die elektrische Isolierung des dritten Halbleitergebietes 4 von der ersten Elektrode 7.

Das dritte Halbleitergebiet 4 ist ferner derart lateral versetzt zum zweiten Halbleitergebiet 3 angeordnet, daß entlang einer Länge L1 auf einer Seite und einer Länge L2 auf der anderen Seite in einer Projektion auf die Oberfläche 20 des ersten Halbleitergebiets 2 sich die beiden Halbleitergebiete 3 und 4 überlappen. Dadurch ist zwischen den beiden p-dotierten Halbleitergebieten 3 und 4 wenigstens ein lateral sich erstreckendes halbleitendes Kanalgebiet 22 im ersten Halbleitergebiet 2 gebildet. Die lateralen Ausdehnungen L1 und L2 des Kanalgebietes 22 auf unterschiedlichen Seiten des Kontaktgebiets 5 können gleich oder auch unterschiedlich groß sein. Typischerweise betragen die Kanallängen L1 und L2 zwischen 1 µm und 5 µm. Die vertikale Ausdehnung d des Kanalgebietes 22 ist durch den Abstand des zweiten Halbleitergebietes 3 vom dritten Halbleitergebiet 4 festgelegt und im allgemeinen zwischen 0,1 µm und 1 µm gewählt.

Das dritte Halbleitergebiet 4 umschließt lateral das Kontaktgebiet 5 und grenzt unmittelbar an das Kontaktgebiet 5 an, so daß L1 + b +L2 = B für die lateralen Ausdehnungen L1, L2, b und B gilt. Das Kontaktgebiet 5 kann aber auch von dem dritten Halbleitergebiet 4 lateral beabstandet sein.

Da die in das Kanalgebiet 22 sich erstreckenden Verarmungszonen 23 und 24 der p-n-Übergänge zwischen den Halbleitergebieten 2 und 3 bzw. 2 und 4 durch die starke Verarmung an Ladungsträgern einen wesentlich höheren elektrischen Widerstand als das erste Halbleitergebiet 2 aufweisen, ist im wesentlichen nur der Innenbereich des Kanalgebietes 22 stromtragfähig, der nach unten durch die Verarmungszone 23 und nach oben durch die Verarmungszone 24 begrenzt ist.

An einer von der genannten Oberfläche 20 des ersten Halbleitergebietes 2 abgewandten weiteren Oberfläche 21 des ersten Halbleitergebietes 2 ist eine zweite Elektrode 6 angeordnet. Zwischen dieser zweiten Elektrode 6 und der ersten Elektrode 7 wird eine Betriebsdurchlaßspannung an die Halbleiteranordnung angelegt. Dabei werden die erste Elektrode 7 mit der Kathode und die zweite Elektrode 6 mit der Anode der Betriebsspannungsquelle verbunden. Bei Vertauschung der Leitungstypen der Halbleitergebiete wird die Polarität der Betriebsspannung entsprechend vertauscht.

Das Verhalten der Halbleiteranordnung bei Anliegen einer Betriebsdurchlaßspannung ist nun abhängig von dem durch die Halbleiteranordnung fließenden elektrischen Strom I zwischen den Elektroden 6 und 7. Dieser elektrische Strom I fließt zwischen den beiden Elektroden 6 und 7 entlang eines durch Pfeile angedeuteten Strompfades zunächst im wesentlichen lateral durch das Kanalgebiet 22 im ersten Halbleitergebiet 2 und dann weitgehend vertikal durch den Volumenbereich des ersten Halbleitergebietes 2. Mit steigender Stromstärke I wächst der Durchlaßspannungsabfall zwischen den Elektroden 6 und 7, so daß das zweite Halbleitergebiet 3 und das dritte Halbleitergebiet 4 negativ gegen die zweite Elektrode 6 vorgespannt werden. Der erhöhte Durchlaßspannungsabfall wirkt als höhere Sperrspannung an den p-n-Übergängen zwischen jeweils dem ersten Halbleitergebiet 2 und dem zweiten Halbleitergebiet 3 bzw. dem dritten Halbleitergebiet 4 und führt damit zu einer Vergrößerung der Verarmungszonen 23 und 24.

Dies hat eine Verminderung des Querschnitts und eine entsprechende Widerstandserhöhung des halbleitenden Bereichs des Kanalgebiets 22 zur Folge. Bei Erreichen eines bestimmten kritischen Stromwertes (Sättigungsstrom) I_{Sat} berühren sich die Verarmungszonen 23 und 24 und schnüren das Kanalgebiet 22 vollständig ab. Wegen des nun erheblich höheren elektrischen Widerstandes im Kanalgebiet 22 geht der Strom nun in Sättigung und bleibt bei gleichbleibender Spannung zwischen den Elektroden 6 und 7 auf dem Sättigungsstromwert I_{Sat}. Der Sättigungsstrom I_{Sat} der Halbleiteranordnung wird durch die geometrischen Abmessungen des Kanalgebiets 22, insbesondere dessen lateralen Ausdehnungen L1 und L2 und vertikale Ausdehnung d, sowie durch die mit der Dotierung festgelegte Ladungsträgerkonzentration des Kanalgebietes 22 auf einen gewünschten Wert eingestellt.

Falls dagegen, wie beispielsweise im Kurzschlußfall, die Spannung zwischen den Elektroden 6 und 7 weiter steigt, nachdem der Strom I bereits den Sättigungsstromwert I_{Sat} erreicht hat, steigt die elektrische Verlustleistung im Kanalgebiet 22 an, und das Kanalgebiet 22 erwärmt sich. Mit der steigenden internen Temperatur im Kanalgebiet 22 nimmt nun die Beweglichkeit derjenigen Ladungsträger, die in den das Kanalgebiet 22 überdeckenden Verarmungszonen 23 und 24 verblieben sind, ab. Die Leitfähigkeit des Kanalgebiets 22 sinkt somit weiter, mit der Folge, daß aufgrund des resultierenden höheren Durchlaßspannungsabfalls zwischen den Elektroden 6 und 7 die beweglichen Ladungsträger aus den Verarmungszonen 23 und 24 im Kanalgebiet 22 verstärkt ausgeräumt werden und insbesondere die Raumladungszone im dritten Halbleitergebiet 4 anwächst. Aufgrund dieses Rückkopplungseffektes begrenzt die Halbleiteranordnung auch einen stark anwachsenden elektrischen Strom wie im Kurzschlußfall schnell auf einen unkritischen Stromwert I_{B}, der im wesentlichen dem Sperrstrom der Halbleiteranordnung bei der gewünschten Sperrspannung, die beispielsweise zwischen etwa 700 V und etwa 1200 V liegt, entspricht.

Wegen des durch das Isolatorgebiet 11 elektrisch isolierten Aufbaus des dritten Halbleitergebietes 4 bleiben die in der Raumladungszone im dritten Halbleitergebiet 4 vorhandenen Ladungsträger gespeichert. Die Leckströme des Isolatorgebiets 11 sollten möglichst gering sein, um eine gute Ladungsspeicherung im dritten Halbleitergebiet 4 zu gewährleisten. Auch in dem vergrabenen zweiten Halbleitergebiet 3 wird die akkumulierte Raumladung gespeichert. Durch diese Ladungsspeicherung bleibt das elektrische Potential im zweiten Halbleitergebiet 3 und im dritten Halbleitergebiet 4 auch bei wieder abnehmender Spannung zwischen den beiden Elektroden 6 und 7 weitgehend erhalten, und das Kanalgebiet 22 bleibt geschlossen. Somit wird mit der Halbleiteranordnung eine schnelle und sichere Begrenzung des Stromes I auf den Sperrstrom I_{B} erreicht.

Der Halbleiter für die Halbleitergebiete 2, 3 und 4 der Halbleiteranordnung ist Siliciumcarbid (SiC). Dotierstoffe für SiC sind Bor und Aluminium für p-Dotierung und Stickstoff für n-Dotierung. Für das Isolatorgebiet 11 wird das Dielektrikum Siliciumdioxid (SiO₂) verwendet, das insbesondere thermisch gewachsen wird. Thermisches Oxid weist hervorragende Isolationseigenschaften auf und kann auf SiC durch Trocken- oder Naßoxidation bei Temperaturen über etwa 1000°C erzeugt werden.

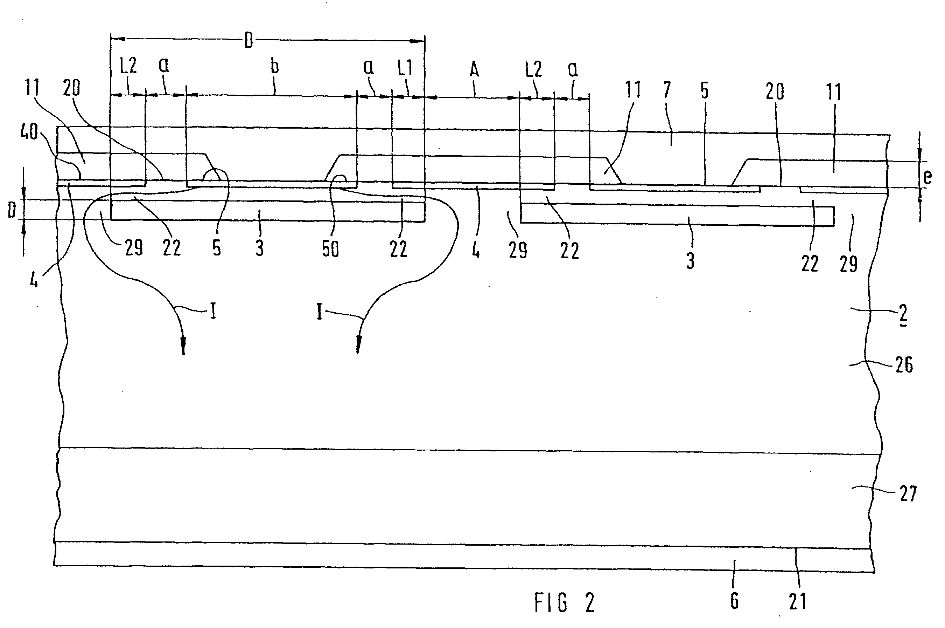

FIG 2 zeigt eine Halbleiteranordnung, bei der das erste Halbleitergebiet 2 aus einem Substrat 27 und einer darauf angeordneten, epitaktisch aufgewachsenen Halbleiterschicht 26 vom gleichen Leitungstyp wie das Substrat 27 zusammengesetzt ist. An der Oberfläche 20 der Halbleiterschicht 26 sind mehrere gleich, aber höher dotierte Kontaktgebiete 5 zueinander beabstandet angeordnet, von denen nur zwei dargestellt sind. Unterhalb der Kontaktgebiete 5 ist in der Halbleiterschicht 26 jeweils ein zur Halbleiterschicht 26 entgegengesetzt dotiertes zweites Halbleitergebiet 3 oder jeweils ein Teilbereich eines zusammenhängenden dritten Halbleitergebietes 3 vergraben. Zwischen den Kontaktgebieten 5 sind jeweils in einem lateralen Abstand und vorzugsweise in einem gleichen Abstand a ein drittes, entgegengesetzt zur Halbleiterschicht 26 dotiertes Halbleitergebiet 4 an der Oberfläche 20 der Halbleiterschicht 26 angeordnet. Der laterale Abstand a der Kontaktgebiete 5 von den dritten Halbleitergebieten 4 liegt im allgemeinen zwischen etwa 1 µm und etwa 3µm.

Eine dielektrische Schicht ist als Isolatorgebiet 11 auf die Oberfläche 20 der Halbleiterschicht 26 aufgebracht. Auf diesem Isolatorgebiet 11 ist eine elektrisch leitende Schicht, vorzugsweise aus Metall oder Polysilicium, angeordnet, die die Kontaktgebiete 5 durch Öffnungen in dem Isolatorgebiet 11 als gemeinsame Elektrode 7 kontaktiert.

Die Halbleitergebiete 3 und 4 verlaufen jeweils im wesentlichen lateral zur Oberfläche 20 des ersten Halbleitergebiets 2. Jeweils ein Halbleitergebiet 4 überlappt in einer Projektion entlang einer Richtung senkrecht zur Oberfläche 20 mit jeweils zwei der Halbleitergebiete 3 und jedes Halbleitergebiet 3 mit jeweils zwei der Halbleitergebiete 4. Dadurch sind wie in FIG 1 wieder lateral verlaufende Kanalgebiete 22 der lateralen Kanallängen L1 bzw. L2 in der Halbleiterschicht 26 gebildet zwischen jeweils einem zweiten Halbleitergebiet 3 und jeweils einem dritten Halbleitergebiet 4. Die laterale Ausdehnung B der vergrabenen zweiten Halbleitergebiete 3 ist B = b + 2a + L1 + L2. Auf der von der Halbleiterschicht 26 abgewandten Seite des Substrats 27 als zweite Oberfläche 21 des ersten Halbleitergebiets 2 ist wieder eine Elektrode 6 angeordnet. Zwischen der Elektrode 6 und der Elektrode 7 wird die Betriebsspannung der Halbleiteranordnung angelegt. Die vergrabenen Halbleitergebiete 3 sind lateral voneinander beabstandet, vorzugsweise mit gleichem Abstand A, oder es sind in einem zusammenhängenden zweiten Halbleitergebiet 3 Öffnungen mit jeweils einer lateralen Ausdehnung A gebildet. Zwischen den zweiten Halbleitergebieten 3 ist dadurch jeweils ein Kanalgebiet 29 des ersten Halbleitergebiets 2 von der lateralen Ausdehnung A und der vertikalen Ausdehnung D gebildet, das im wesentlichen vertikal zur Oberfläche 20 verläuft. Der halbleitende Bereich in jedem Kanalgebiet 29 ist lateral begrenzt durch die nicht dargestellten Verarmungszonen der von der Halbleiterschicht 26 und den zweiten Halbleitergebieten 3 gebildeten p-n-Übergänge.

Die laterale Ausdehnung A der vertikalen Kanalgebiete 29 ist vorzugsweise so klein gewählt, daß die zwischen den beiden Elektroden 6 und 7 anlegbare maximale Sperrspannung zumindest weitgehend der maximalen Volumensperrspannung entspricht, die der p-n-Übergang zwischen den Halbleitergebieten 2 und 3 an der Unterseite der zweiten Halbleitergebiete 3 tragen kann. Dies entspricht einem zumindest weitgehend planaren Verlauf der Äquipotentiallinien im Sperrfall (reduzierter Spannungsdurchgriff). Typische Werte für die laterale Ausdehnung A liegen zwischen 1 µm und 10 µm. Die Dicke e des Isolatorgebiets 11 ist hinreichend groß gewählt, so daß bei entsprechend schmal (kleines A) gewählten vertikalen Kanalgebieten 29 eine Potentialdifferenz von 50 V zwischen den dritten Halbleitergebieten 4 und der Elektrode 7 nicht überschritten wird.

Bei Anlegen einer in Durchlaßrichtung gepolten Betriebsspannung fließt zwischen der Elektrode 7 und der Elektrode 6 ein Strom I entlang der dargestellten Pfeile, der zunächst durch die lateralen Kanalgebiete 22 und danach in praktisch vertikaler Richtung zur Oberfläche 20 durch die vertikalen Kanalgebiete 29 in der Halbleiterschicht 26 und dann im wesentlichen vertikal durch die Halbleiterschicht 26 und das Substrat 27 zur zweiten Elektrode 6 verläuft.

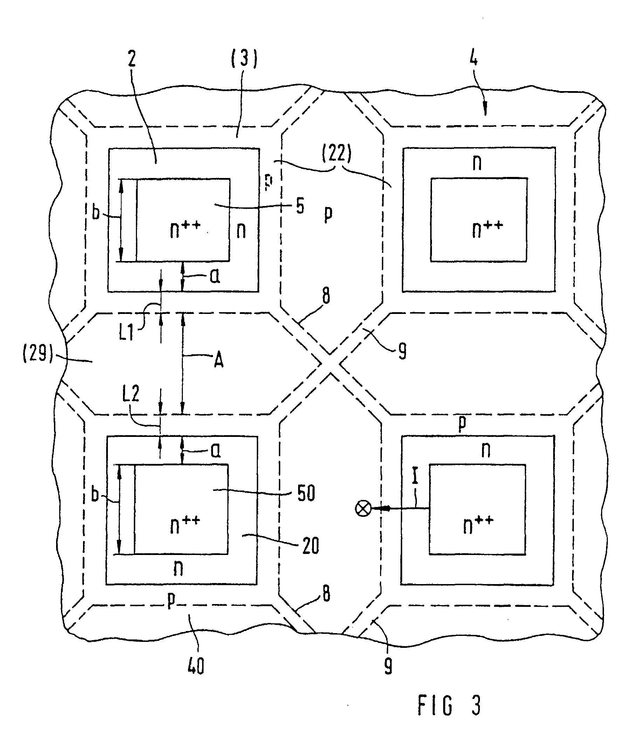

FIG 3 zeigt eine Ausführungsform einer Halbleiteranordnung in einer Draufsicht auf die Halbleiteroberfläche ohne Elektrode und Isolator. In einem Zelldesign sind mehrere wenigstens annähernd quadratische Zellen vorgesehen aus jeweils einem als Quadrat der Seitenlänge b gebildeten und n⁺⁺-dotierten Sourcegebiet als Kontaktgebiet 5, das in einer n-dotierten Halbleiterschicht als erstem Halbleitergebiet 2 implantiert ist, einem das n⁺⁺-Kontaktgebiet 5 in einem Abstand a umgebenden p-dotierten dritten Halbleitergebiet 4 und einem unterhalb des Kontaktgebietes 5 durch Implantation vergrabenen, p-dotierten zweiten Halbleitergebiet 3, das gestrichelt dargestellt ist. Das dritte Halbleitergebiet 4 mit der Oberfläche 40 ist vorzugsweise an der gesamten Oberfläche 20 des ersten Halbleitergebietes 2 implantiert mit Ausnahme der quadratischen Aussparungen für die Kontaktgebiete 5 mit den Oberflächen 50 und die die Kontaktgebiete 5 umgebenden Teilbereiche der Oberfläche 20 des ersten Halbleitergebietes 2. In dem quadratringförmigen Überlappungsbereich der Breite L1 oder L2 ist unterhalb des dritten Halbleitergebietes 4 und oberhalb des zweiten Halbleitergebietes 3 wieder jeweils ein Kanalgebiet 22 gebildet. Um die vergrabenen zweiten Halbleitergebiete 3 auf gemeinsames Potential zu legen, sind diese zweiten Halbleitergebiete 3 über kreuzförmig verlaufende p-dotierte Verbindungen 8 und 9 im ersten Halbleitergebiet 2 miteinander verbunden. Zwischen den Verbindungen 8 und 9 und den benachbarten dritten Halbleitergebieten 3 sind jeweils ein durchgehendes, in etwa in Form einer Raute der Breite A und vertikal zur Oberfläche 40 bzw. 20 verlaufendes Kanalgebiet 29 im ersten Halbleitergebiet 2 unterhalb des dritten Halbleitergebietes 4 angeordnet. Der Strom I fließt von den Kontaktgebieten 5 zunächst lateral (d.h. waagrecht oder horizontal) durch das laterale Kanalgebiet 22 und anschließend annähernd vertikal durch die benachbarten vertikalen Kanalgebiete 29.

Für das Halbleitermaterial SiC werden folgende Dotierstoffkonzentrationen gewählt:
Für das erste Halbleitergebiet 2, insbesondere die Halbleiterschicht 26, zwischen etwa 1 · 10¹⁶ cm⁻³ (für eine Sperrspannung von etwa 700 V) und etwa 6 · 10¹⁵ cm⁻³ (für eine Sperrspannung von etwa 1200 V), für das Substrat 27 auch deutlich mehr als 10¹⁸ cm⁻³ und für die zweiten Halbleitergebiete 3 und die dritten Halbleitergebiete 4 zwischen etwa 1 · 10¹⁸ cm⁻³ und etwa 2 · 10¹⁹ cm⁻³, vorzugsweise etwa 5 · 10¹⁶ cm⁻³.

Alle beschriebenen Ausführungsformen der Halbleiteranordnung können in verschiedenen Topologien ausgeführt werden, insbesondere in einem Zelldesign oder auch in einer kammartigen Struktur.

Die bisher beschriebenen Halbleiteranordnungen sind unipolare Bauelemente, die in hervorragender Weise zur Begrenzung von Kurzschlußgleichströmen geeignet sind und dabei eigensicher und ohne Ansteuerung (passiv) arbeiten. Durch die Auslegung der Halbleiteranordnung als Strombegrenzer kann ein gewünschter Sättigungsstrom I_{Sat} eingestellt werden, der oberhalb eines Nennstrombereiches und auch eines regulären, noch zu tolerierenden Überstrombereiches liegt und ab dem die Halbleiteranordnung den Strom selbsttätig unter Aufnahme von Spannung auf den niedrigeren Sperrstrom I_{B} begrenzt.

In einer nicht dargestellten, auch für Wechselspannungen geeigneten Ausführungsform eines Strombegrenzers werden eine Serienschaltung aus einer ersten Halbleiteranordnung gemäß FIG 1 oder FIG 2 und einer ersten Diode für die Rückwärtsspannung und eine weitere Serienschaltung aus einer zweiten Halbleiteranordnung gemäß FIG 1 oder FIG 2 und einer zweiten Diode für deren Rückwärtsspannung antiparallel geschaltet. Die beiden Dioden können p-n-Gleichrichterdioden oder auch Schottky-Dioden, insbesondere auf SiC-Basis, sein. Die Kennlinie dieses Wechselstrombegrenzers ist dann mit den Diodenschwellspannungen behaftet.

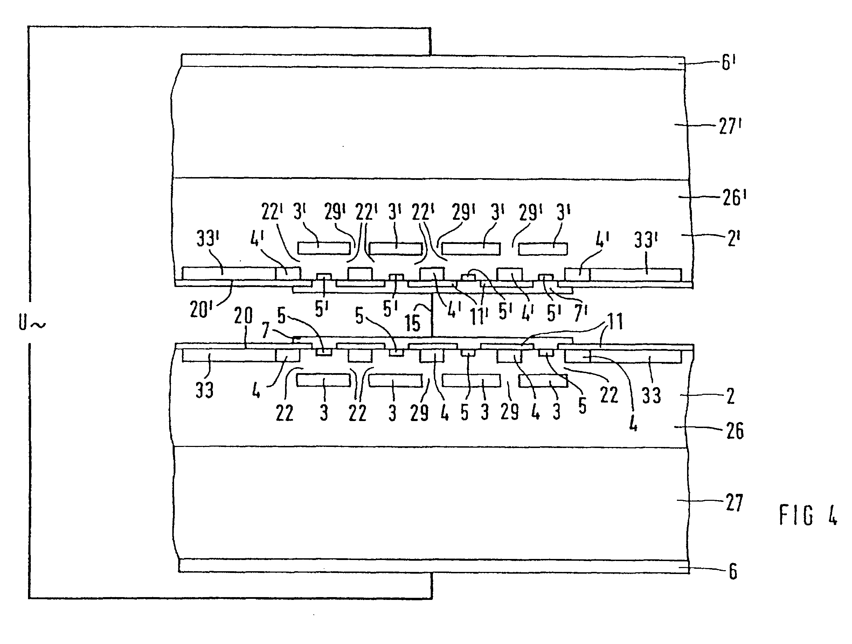

Eine besonders vorteilhafte Ausführungsform eines Wechselstrombegrenzers ist in FIG 4 dargestellt. Zwei gleichartige Halbleiteranordnungen, die ähnlich wie in FIG 2 aufgebaut sind, sind antiseriell geschaltet, so daß jeweils eine der beiden Halbleiteranordnungen eine Kurzschlußhalbwelle (Strompolarität) begrenzt. Dazu sind die ersten Elekroden 7 und 7' der beiden Halbleiteranordnungen elektrisch über eine elektrische Verbindung 15 miteinander kontaktiert und die beiden zweiten Elektroden 6 und 6' jeweils mit einem Pol der Wechselspannung elektrisch verbunden. Im Unterschied zu der Ausführungsform gemäß FIG 2 sind die dritten Halbleitergebiete 4 bzw. 4' tiefer als die Kontaktgebiete 5 bzw. 5' ausgebildet und die Kanalgebiete 22 und 29 geometrisch anders bemessen. Ferner sind die äußersten dritten Halbleitergebiete 4 bzw. 4' von einem entgegengesetzt zur Halbleiterschicht 26 bzw. 26' dotierten flächigen Randabschluß begrenzt zur Reduzierung der Feldstärke an der Oberfläche 20 bzw. 20' und Passivierung. Der Ladungsspeichereffekt in den dritten Halbleitergebieten 4 und 4' verhindert im Kurzschlußfall ein wiederholtes Anschalten während der folgenden Wechselspannungsperioden, so daß der Strom auf den niedrigen Sperrstrom I_{B} begrenzt bleibt.

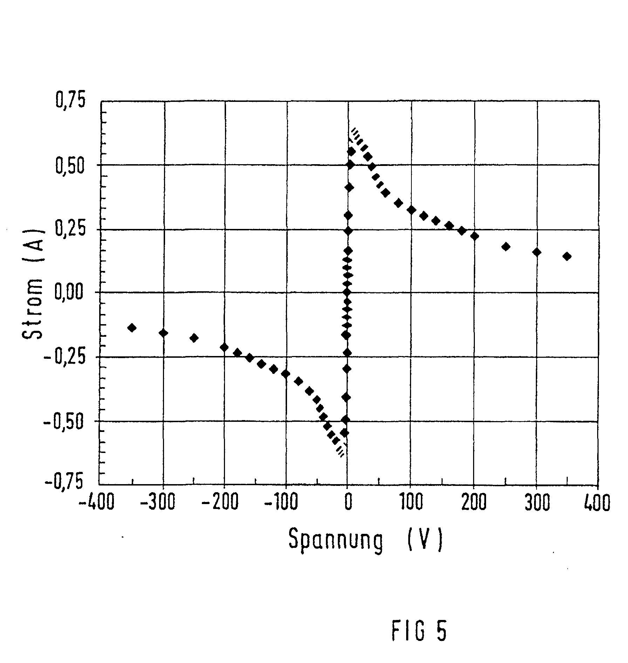

Die gemessene Strom-Spannungs-Kennlinie eines in SiC gebildeten Wechselstrombegrenzers gemäß FIG 4 ist in FIG 5 gezeigt. Diese Kennlinie zeigt die hervorragende Eignung der Halbleiteranordnung als stromlimitierendes Bauelement.

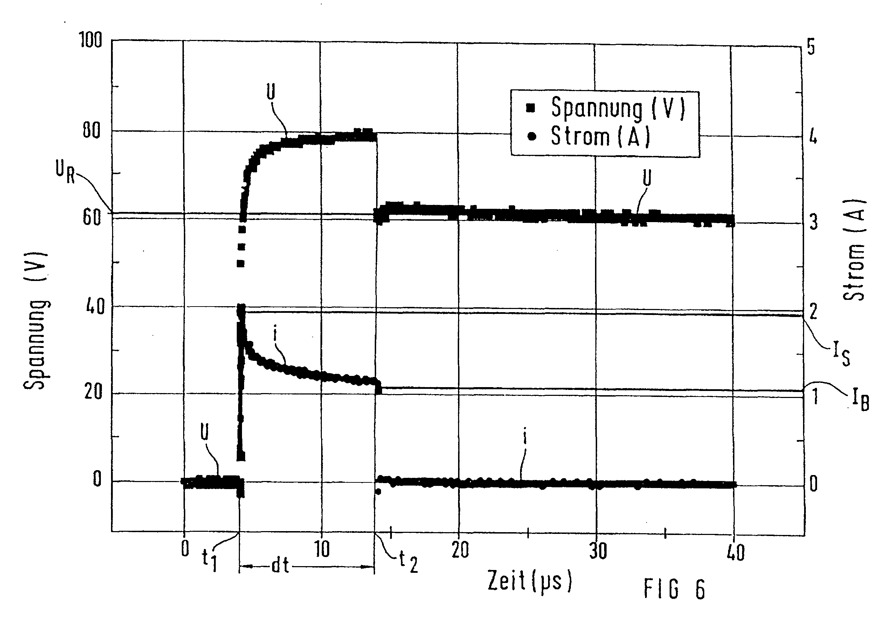

Die FIG 6 zeigt die Meßkurven von Strom I und Spannung U einer Halbleiteranordnung in deren Abhängigkeit von der Zeit t. An die Elektroden der Halbleiteranordnung wurde zum Zeitpunkt t₁ ein Spannungspuls der Höhe 80 V und der zeitlichen Länge dt = 10 µs in einem Kurzschluß angelegt. Der Strom I nimmt schlagartig zu und wird bei einem Sättigungsstromwert I_{S} = 2 A von der Halbleiteranordnung schnell innerhalb weniger µs auf einen Sperrstrom I_{B} von nur etwa 1 A begrenzt. Nach Abschalten des Spannungspulses zum Zeitpunkt t₂ geht der Strom I natürlich wieder auf 0 A zurück. Interessant ist jedoch, daß die Spannung U über der Halbleiteranordnung nicht auch auf 0 V zurückgeht, sondern auf einer Restspannung U_{R} von etwa 60 V praktisch konstant über mehr als 25 µs verharrt. Dies zeigt eindrucksvoll den Ladungsspeichereffekt in den Halbleitergebieten 3 und 4 der Halbleiteranordnung.

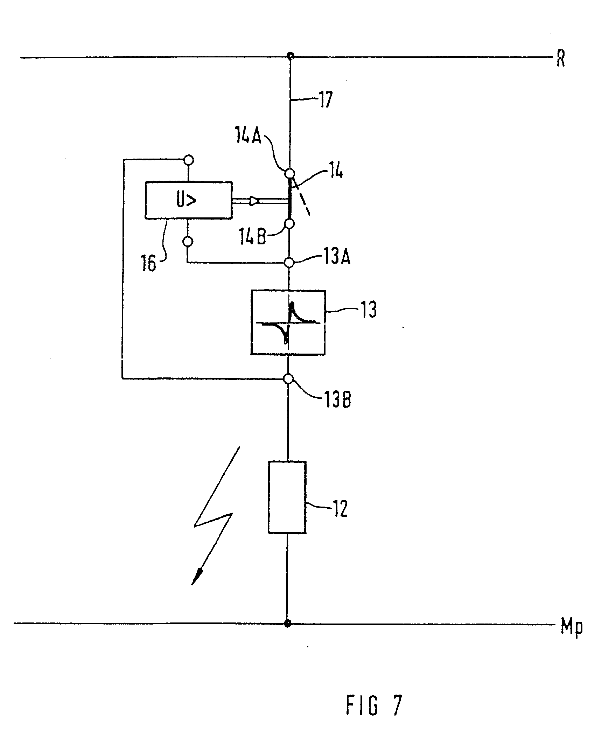

FIG 7 veranschaulicht eine Schalteinrichtung in einem Leitungsabzweig 17 zwischen einer Phase R und Erdpotential Mp eines elektrischen Versorgungsnetzes, beispielsweise einer Gebäudeinstallation, für einen elektrischen Verbraucher 12. Die Schalteinrichtung umfaßt einen elektronischen Strombegrenzer 13, der insbesondere gemäß einer der FIG 1 bis 4 ausgebildet sein kann, einen Überspannungsauslöser 16, der den Spannungsabfall zwischen zwei Abgriffspunkten 13A und 13B des Strombegrenzers 13 abgreift, und ein in Reihe zum Strombegrenzer 13 vor die Last 12 in den Leitungsabzweig 17 geschaltetes Schaltrelais 14. Das Schaltrelais 14 wird von dem Überspannungsauslöser 16 bei Überschreiten einer Grenzspannung am Strombegrenzer 13 ausgelöst (geöffnet) zur galvanischen Trennung des Verbrauchers 12 vom Netz (R) im Kurzschlußfall. Das Schaltrelais 14 muß dabei nicht besonders schnell sein noch werden seine Kontakte durch Lichtbögen bei der Strombegrenzung beansprucht, da der elektronische Strombegrenzer 13 sehr schnell in deutlich weniger als einer Millisekunde den Strom begrenzt.

## Patentansprüche

1. Halbleiteranordnung umfassend
a) ein erstes Halbleitergebiet (2), das an einer ersten Oberfläche (20) wenigstens ein mit einer ersten Elektrode (7) kontaktiertes Kontaktgebiet (5) aufweist und an einer zweiten Oberfläche (21) mit einer zweiten Elektrode (6) kontaktiert ist,
b) wenigstens ein zweites Halbleitergebiet (3), das mit dem ersten Halbleitergebiet (2) einen p-n-Übergang bildet,
c) wenigstens ein drittes Halbleitergebiet (4), das mit dem ersten Halbleitergebiet (2) einen p-n-Übergang bildet,
**dadurch gekennzeichet**, daß
d) das dritte Halbleitergebiet (4) an seiner nicht an das erste Halbleitergebiet (2) angrenzenden-Oberfläche (40) isoliert ist, so daß Ladungen im dritten Halbleitergebiet (4) speicherbar sind,
e) das erste Halbleitergebiet (2) wenigstens ein in einem Strompfad zwischen den beiden Elektroden (6,7) liegendes Kanalgebiet (22) aufweist, das bei Erreichen eines vorgegebenen Sättigungsstromes zwischen den beiden Elektroden (6,7) von Verarmungszonen (23, 24 ) der genannten p-n-Übergänge abgeschnürt wird, wonach der Strom auf einen Wert unterhalb des Sättigungsstromes begrenzt wird.

2. Halbleiteranordnung nach Anspruch 1, bei der das zweite Halbleitergebiet (3) innerhalb des ersten Halbleitergebietes (2) unterhalb des Kontaktgebiets (5) angeordnet ist und sich in allen Richtungen parallel zur Oberfläche (20) des ersten Halbleitergebiets (2) weiter erstreckt als das Kontaktgebiet (5).

3. Halbleiteranordnung nach Anspruch 1 oder Anspruch 2, bei der das dritte Halbleitergebiet (4) das Kontaktgebiet (5) parallel zur ersten Oberfläche (20) des ersten Halbleitergebietes (2) umschließt.

4. Halbleiteranordnung nach einem der Ansprüche 1 bis 3, bei der die zweite Oberfläche (21) des ersten Halbleitergebietes (2) von der ersten Oberfläche (20) abgewandt ist.

5. Halbleiteranordnung nach einem der vorhergehenden Ansprüche, bei der das erste Halbleitergebiet (2) an seiner ersten Oberfläche (20) mehrere Kontaktgebiete (5) aufweist.

6. Halbleiteranordnung nach Anspruch 5, bei der unterhalb der Kontaktgebiete (5) ein zusammenhängendes zweites Halbleitergebiet (3) angeordnet ist, das in allen Richtungen parallel zur ersten Oberfläche (20) des ersten Halbleitergebietes (2) weiter ausgedehnt ist als die Gesamtheit der Kontaktgebiete (5).

7. Halbleiteranordnung nach Anspruch 2 und Anspruch 5, bei der unterhalb jedes Kontaktgebietes (5) ein zugehöriges zweites Halbleitergebiet (3) im ersten Halbleitergebiet (2) angeordnet ist.

8. Halbleiteranordnung nach Anspruch 4 und Anspruch 6, bei der durch Öffnungen in dem zusammenhängenden zweiten Halbleitergebiet (3) jeweils Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

9. Halbleiteranordnung nach Anspruch 4 und Anspruch 7, bei der zwischen den den Kontaktgebieten (5) zugeordneten zweiten Halbleitergebiete (3) Kanalgebiete (29) des ersten Halbleitergebietes (2) verlaufen, die im Strompfad elektrisch in Reihe zu jeweils wenigstens einem der den Kontaktgebieten (5) zugeordneten Kanalgebieten (22) liegen.

10. Halbleiteranordnung nach einem der Ansprüche 5 bis 9, bei der eine allen Kontaktgebieten (5) gemeinsame erste Elektrode (7) vorgesehen ist.

11. Halbleiteranordnung nach einem der vorhergehenden Ansprüche, bei der jedes dritte Halbleitergebiet (4) an seiner nicht an das erste Halbleitergebiet (2) angrenzenden Oberfläche (40) mit einem Isolatorgebiet (11) bedeckt ist.

12. Halbleiteranordnung nach einem der vorhergehenden Ansprüche, bei der jedes Isolatorgebiet (11) eine Durchbruchspannung von wenigstens 20 V, insbesondere von wenigstens 50 V aufweist.

13. Halbleiteranordnung nach einem der vorhergehenden Ansprüche, bei der die Halbleitergebiete (2,3,4) aus Siliciumcarbid gebildet sind.

14. Halbleiteranordnung nach einem der vorhergehenden Ansprüche, bei der jedes Isolatorgebiet (11) mit Siliciumdioxid gebildet ist.

15. Halbleiteranordnung nach Anspruch 13 und Anspruch 14, bei der das Siliciumdioxid thermisch gewachsen ist.

16. Verwendung einer Halbleiteranordnung nach einem der vorhergehenden Ansprüche für einen Strombegrenzer (13) zum Begrenzen von Gleichströmen zwischen einer Stromquelle (R) und einem elektrischen Verbraucher (12), wobei eine Elektrode (7) der Halbleiteranordnung mit der Stromquelle (R) und die andere Elektrode (6) mit dem Verbraucher (12) elektrisch verbindbar ist.

17. Verwendung einer Halbleiteranordnung nach einem der Ansprüche 1 bis 15 für einen Strombegrenzer (13) zum Begrenzen von Wechselströmen zwischen einer Stromquelle (R) und einem elektrischen Verbraucher (12), wobei zwei der Halbleiteranordnungen antiseriell zwischen die Stromquelle (R) und den Verbraucher (12) geschaltet sind.

## Claims

1. Semiconductor configuration, comprising
a) a first semiconductor region (2), that has on a first surface (20) at least one contact region (5) in contact with a first electrode (7) and is in contact with a second electrode (6) on a second surface (21),
b) at least a second semiconductor region (3), that forms a p-n junction with the first semiconductor region (2),
c) at least a third semiconductor region (4), that forms a p-n junction with the first semiconductor region (2),
**characterized in that**
d) the third semiconductor region (4) is insulated on its surface (40) not adjoining the first semiconductor region (2), so that charges can be stored in the third semiconductor region (4),
e) the first semiconductor region (2) has at least one channel region (22) lying in the current path between the two electrodes (6, 7), this being pinched off by depletion zones (23, 24) of said p-n junctions when a predetermined saturation current is attained between the two electrodes (6, 7), following which the current is limited to a value below the saturation current.

2. Semiconductor configuration according to claim 1, in which the second semiconductor region (3) is arranged inside the first semiconductor region (2) below the contact region (5) and extends further than the contact region (5) in all directions parallel to the surface (20) of the first semiconductor region (2).

3. Semiconductor configuration according to claim 1 or claim 2, in which the third semiconductor region (4) encloses the contact region (5) parallel to the first surface (20) of the first semiconductor region (2).

4. Semiconductor configuration according to one of claims 1 to 3, in which the second surface (21) of the first semiconductor region (2) faces away from the first surface (20).

5. Semiconductor configuration according to one of the preceding claims, in which the first semiconductor region (2) has several contact regions (5) on its first surface (20).

6. Semiconductor configuration according to claim 5, in which a coherent second semiconductor region (3) is arranged below the contact regions (5) and is extended further than the totality of the contact regions (5) in all directions parallel to the first surface (20) of the first semiconductor region (2).

7. Semiconductor configuration according to claim 2 and claim 5, in which a related second semiconductor region (3) is arranged in the first semiconductor region (2) below each contact region (5).

8. Semiconductor configuration according to claim 4 and claim 6, in which channel regions (29) of the first semiconductor region (2) run respectively through openings in the coherent second semiconductor region (3), the channel regions being connected electrically in series in the current path to at least one of the channel regions (22) assigned to the contact regions (5).

9. Semiconductor configuration according to claim 4 and claim 7, in which channel regions (29) of the first semiconductor region (2) run between the second semiconductor regions (3) assigned to the contact regions (5), the channel regions being electrically connected in series in the current path respectively to at least one of the channel regions (22) assigned to the contact regions (5).

10. Semiconductor configuration according to one of claims 5 to 9, in which a first electrode (7) common to all contact regions (5) is provided.

11. Semiconductor configuration according to one of the preceding claims, in which every third semiconductor region (4) is covered by an insulator region (11) on its surface (40) not adjoining the first semiconductor region (2).

12. Semiconductor configuration according to one of the preceding claims, in which each insulator region (11) has a breakdown voltage of at least 20 V, in particular of at least 50 V.

13. Semiconductor configuration according to one of the preceding claims, in which the semiconductor regions (2, 3, 4) are formed of silicon carbide.

14. Semiconductor configuration according to one of the preceding claims, in which each insulator region (11) is formed by silicon dioxide.

15. Semiconductor configuration according to claim 13 and claim 14, in which the silicon dioxide is grown thermally.

16. Use of a semiconductor configuration according to one of the preceding claims for a current limiter (13) to limit direct currents between a current source (R) and an electrical consumer (12), one electrode (7) of the semiconductor configuration being electrically connectable to the current source (R) and the other electrode (6) to the consumer (12).

17. Use of a semiconductor configuration according to one of claims 1 to 15 for a current limiter (13) to limit alternating currents between a current source (R) and an electrical consumer (12), two of the semiconductor configurations being reverse-connected in series between the current source (R) and the consumer (12).

## Revendications

1. Dispositif à semiconducteur comprenant
a) une première zone (2) semiconductrice, qui comprend sur une première surface (20) au moins une zone (5) de contact mise en contact avec une première électrode (7) et sur une deuxième surface (21) mise en contact avec une deuxième électrode,
b) au moins une deuxième zone (3) semiconductrice, qui forme avec la première zone (2) semiconductrice, une première jonction p-n,
c) au moins une troisième zone (4) semiconductrice, qui forme avec la première zone (2) semiconductrice, une jonction p-n,
**caractérisé en ce que**
d) la troisième zone (4) semiconductrice est isolée sur sa surface (40) qui n'est pas adjacente à la première zone (2) semiconductrice, de manière à pouvoir emmagasiner des charges dans la troisième zone (4) semiconductrice,
e) la première zone (2) semiconductrice comprend au moins une zone (22) de canal se trouvant dans un trajet de courant entre les deux électrodes (6, 7), qui, lorsqu'un courant de saturation prescrit est atteint entre les deux électrodes (6, 7), est étranglée par des zones (23, 24) d'appauvrissement desdites jonctions p-n, le courant étant ainsi limité à une valeur inférieure au courant de saturation.

2. Dispositif à semiconducteur suivant la revendication 1, dans lequel la deuxième zone (3) semiconductrice est disposée à l'intérieur de la première zone (2) semiconductrice en dessous de la zone (5) de contact et s'étend, dans toutes les directions parallèlement à la première surface (1) de la première zone (2) semiconductrice, au-delà de la zone (5) de contact.

3. Dispositif à semiconducteur suivant la revendication 1 ou la revendication 2, dans lequel la troisième zone (4) semiconductrice entoure la zone (5) de contact, parallèlement à la première surface (20) de la première zone (2) semiconductrice.

4. Dispositif à semiconducteur suivant l'une des revendications 1 à 3, dans lequel la deuxième surface (21) de la première zone (2) semiconductrice est éloignée de la première surface (20).

5. Dispositif à semiconducteur suivant l'une des revendications précédentes, dans lequel la première zone (2) semiconductrice présente sur sa première surface (20) plusieurs zones (5) de contact.

6. Dispositif à semiconducteur suivant la revendication 5, dans lequel il est prévu, en dessous de la zone (5) de contact, une deuxième zone (3) semiconductrice d'un seul tenant, qui s'étend, dans toutes les directions parallèlement à la première surface (20) de la première zone (2) semiconductrice, au-delà de la totalité des zones (5) de contact.

7. Dispositif à semiconducteur suivant la revendication 2 et la revendication 5, dans lequel il est prévu, en dessous de chaque zone (5) de contact, une deuxième zone (3) semiconductrice associée dans la première zone (2) semiconductrice.

8. Dispositif à semiconducteur suivant la revendication 4 et la revendication 6, dans lequel il s'étend dans des ouvertures ménagées dans la deuxième zone (3) semiconductrice d'un seul tenant, respectivement des zones (29) de canal de la première zone (2) semiconductrice, qui sont disposées, dans le trajet de courant, électriquement en série avec respectivement au moins l'une des zones (22) de canal associée aux zones (5) de contact.

9. Dispositif à semiconducteur suivant la revendication 4 et la revendication 7, dans lequel il s'étend entre les deuxièmes zones (3) semiconductrices associées aux zones (5) de contact, des zones (29) de contact de la première zone (2) semiconductrice, qui sont, dans le trajet de courant, électriquement en série avec respectivement au moins l'une des zones (22) de canal associée aux zones (5) de contact.

10. Dispositif à semiconducteur suivant l'une des revendications 5 à 9, dans lequel il est prévu une première électrode (7) commune à toutes les zonas (5) de contact.

11. Dispositif à semiconducteur suivant l'une des revendications précédentes, dans lequel une zone (4) de contact sur trois est recouverte, sur sa surface (40) qui n'est pas adjacente à la première zone (2) semiconductrice, d'une zone (11) d'isolement.

12. Dispositif à semiconducteur suivant l'une des revendications précédentes, dans lequel chaque zone (11) d'isolement a une tension de claquage d'au moins 20 V, notamment d'au moins 50 V.

13. Dispositif à semiconducteur suivant l'une des revendications précédentes, dans lequel les zones (2, 3, 4) semiconductrices sont en carbure de silicium.

14. Dispositif à semiconducteur suivant l'une des revendications précédentes, dans lequel chaque zone (11) d'isolement est en dioxyde de silicium.

15. Dispositif à semiconducteur suivant la revendication 13 et la revendication 14, dans lequel le dioxyde de silicium a été obtenu par croissance thermique.

16. Utilisation d'un dispositif à semiconducteur suivant l'une des revendications précédentes, pour un limiteur (13) de courant en vue de limiter les courants continus entre une source (R) de courant et un appareil (12) consommant de l'électricité, une électrode (7) du dispositif à semiconducteur étant reliée électriquement à la source (R) de courant et l'autre électrode (6) à l'appareil (12) consommateur.

17. Utilisation d'un dispositif à semiconducteur suivant l'une des revendications 1 à 15, pour un limiteur (13) de courant, afin de limiter des courants alternatifs entre une source (R) et un appareil (12) consommant de l'électricité, deux dispositifs à semiconducteur étant montés tête-bêche, entre la source (R) de courant et l'appareil (12) consommateur.
